# EUROPEAN PATENT APPLICATION

(11) **EP 4 550 990 A1**
(43) Date of publication of application: **07.05.2025**
(21) Application number: 24206740.3
(22) Date of filing: 15.10.2024
(51) Int. Cl.: H10K 59/38, H10K 59/80

(54) **DISPLAY DEVICE**

(30) Priority: 01.11.2023 KR 20230149021
(71) Applicant: Samsung Display Co., Ltd, Gyeonggi-do (KR)
(72) Inventor: KIM, Sunkwang, Yongin-si (KR); KIM, Kang-Woo, Yongin-si (KR); OH, Young-Sik, Yongin-si (KR); LEE, Dong-Yoon, Yongin-si (KR); LEE, Seongyoung, Yongin-si (KR); JO, Kangmoon, Yongin-si (KR)
(74) Representative: Marks & Clerk LLP

(57) **Abstract**

A display device includes a display area including a transmissive area and a non-display area adjacent to the display area. The display device includes a display panel including a light emitting element layer and a light conversion panel on the display panel. The light conversion panel includes a base layer, a color filter under the base layer, a low refractive layer under the color filter, a first capping layer under the low refractive layer, and a light control layer under the color filter and including a partition pattern, a plurality of light control portions spaced apart from each other by the partition pattern, and a second capping layer under the partition pattern and the light control portions. The low refractive layer is provided with a transmission opening defined therethrough to correspond to the transmissive area.

## Description

### BACKGROUND

### 1. Field

Embodiments of the present disclosure relate to a transparent display device. For example, embodiments of the present disclosure relate to a transparent display device having improved light transmissivity.

### 2. Description of Related Art

Various multimedia display devices, such as televisions, mobile phones, tablet computers, and game devices, include a display panel and a light conversion panel to provide a user with image information.

The display panel includes a light emitting element and a pixel driving circuit to drive the light emitting element. The light conversion panel may include a light controller including quantum dots, and a source light provided from the display panel is converted into lights having colors different from each other by the light controller. The light conversion panel may include a color filter, and the color filter improves a color purity and a light extraction efficiency and reduces a reflection of an external light.

Recently, a transparent display device including a transmissive area in a display area is being developed. Research is being conducted to improve a transmittance of the transmissive area of the transparent display device.

### SUMMARY

Embodiments of the present disclosure provide a transparent display device having improved transmittance in a transmissive area thereof.

Embodiments of the present disclosure provide a display device including a display area including a transmissive area and a non-display area adjacent to the display area. The display device includes a display panel including a light emitting element layer and a light conversion panel on the display panel. The light conversion panel includes a base layer, a color filter under the base layer, a low refractive layer under the color filter, a first capping layer under the low refractive layer, and a light control layer under the color filter and including a partition pattern, a plurality of light control portions spaced apart from each other by the partition pattern, and a second capping layer under the partition pattern and the light control portions. The low refractive layer is provided with a transmission opening defined therethrough to correspond to the transmissive area.

The color filter may not overlap the transmissive area.

The base layer may include a lower surface adjacent to the display panel, and the lower surface of the base layer may be exposed through the light transmission opening.

The first capping layer may be directly on the lower surface of the base layer exposed through the transmission opening.

The second capping layer may be directly under the first capping layer in the transmissive area.

The display device may further include a filling layer between the display panel and the light conversion panel.

Each of the first capping layer and the second capping layer may include an inorganic material.

The low refractive layer may include an organic material.

The partition pattern may surround the transmissive area when viewed in a plane, the partition pattern may include a side surface adjacent to the transmissive area, and the side surface of the partition pattern may be covered by the second capping layer.

The partition pattern and the light control portions may not overlap the transmissive area.

The display area may further include a pixel area, and the pixel area may be spaced apart from the transmissive area.

Embodiments of the present disclosure provide a display device including a display area including a pixel area and a transmissive area spaced apart from the pixel area and a non-display area adjacent to the display area. The display device includes a display panel including a light emitting element layer and a light conversion panel on the display panel. The light conversion panel includes a base layer, a color filter that does not overlap the transmissive area and is under the base layer, a low refractive layer provided with a transmission opening defined therethrough and corresponding to the transmissive area and disposed under the color filter, a first capping layer directly under the base layer exposed through the transmission opening, and a second capping layer under the first capping layer.

The second capping layer may be directly under the first capping layer in the transmissive area.

The display device may further include a partition pattern surrounding the transmissive area and the pixel area and under the first capping layer and a plurality of light control portions under the first capping layer to correspond to the pixel area.

The partition pattern may include a side surface adjacent to the transmissive area, and the side surface of the partition pattern may be covered by the second capping layer.

The partition pattern may include a lower surface adjacent to the display panel, and the lower surface of the partition pattern may be covered by the second capping layer.

The light control portions may include a lower surface adjacent to the display panel, and the lower surface of the light control portions may be covered by the second capping layer.

The display device may further include a filling layer between the display panel and the light conversion panel.

Each of the first capping layer and the second capping layer may include an inorganic material.

The low refractive layer may include an organic material.

At least some of the above and other features of the invention are set out in the claims.

According to the above, the display device includes the light conversion panel having improved transmittance, and thus, the transmittance in the transmissive area is improved.

### BRIEF DESCRIPTION OF THE DRAWINGS

The above and other features of embodiments of the present disclosure will become readily apparent by reference to the following detailed description when considered in conjunction with the accompanying drawings wherein:
FIG. 1A is a perspective view of a display device according to an embodiment of the present disclosure;
FIG. 1B is a cross-sectional view of a display device according to an embodiment of the present disclosure;
FIG. 2 is a plan view of a display panel according to an embodiment of the present disclosure;
FIG. 3 is an equivalent circuit diagram of a pixel according to an embodiment of the present disclosure;
FIG. 4A is an enlarged plan view of a display area according to an embodiment of the present disclosure;
FIG. 4B is an enlarged plan view of a display area according to an embodiment of the present disclosure;
FIG. 5 is a cross-sectional view of a display device according to an embodiment of the present disclosure;
FIGS. 6A-6B are cross-sectional views of light emitting layers according to various embodiments of the present disclosure;
FIG. 7 is a cross-sectional view of a light conversion panel according to an embodiment of the present disclosure;
FIGS. 8A-8C are plan views of color filters according to an embodiment of the present disclosure; and
FIG. 8D is a plan view of a partition pattern according to an embodiment of the present disclosure.

### DETAILED DESCRIPTION

Embodiments of the present disclosure may be variously modified and realized in many different forms, and thus, example embodiments will be illustrated in the drawings and described in more detail hereinbelow. However, the present disclosure should not be limited to the specific disclosed forms, and should be construed to include all modifications, equivalents, or replacements included in the scope of the present disclosure.

As used herein, the singular forms, "a", "an" and "the" are intended to include the plural forms as well, unless the context clearly indicates otherwise.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Spatially relative terms, such as "below", "lower", "above", "upper" and the like, may be used herein for ease of description to describe one element or feature's relationship to other elements or features as shown in the figures.

In the present disclosure, the term "on" may mean that a portion of an element is provided at a lower portion as well as an upper portion of another element.

In the present disclosure, when an element is referred to as being "directly on" another element, there are no intervening elements present between a layer, film, region, or substrate and another layer, film, region, or substrate. For example, the term "directly on" may mean that two layers or two members are provided without employing additional adhesive therebetween.

As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element and vice versa without departing from the scope of the present disclosure.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Like numerals refer to like elements throughout. In the drawings, the thickness, ratio, and dimension of components may be exaggerated for effective description of the technical content.

Hereinafter, embodiments of the present disclosure will be described with reference to accompanying drawings.

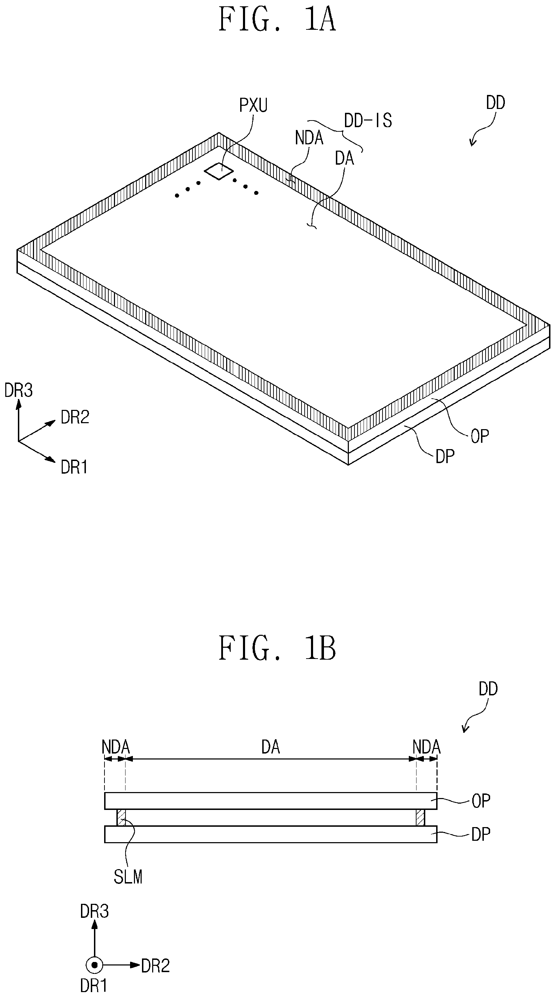

FIG. 1A is a perspective view of a display device DD according to an embodiment of the present disclosure. FIG. 1B is a cross-sectional view of the display device DD according to an embodiment of the present disclosure.

Referring to FIG. 1A, the display device DD may display an image through a display surface DD-IS. The display surface DD-IS may be substantially parallel to a plane defined by a first direction DR1 and a second direction DR2. An upper surface of a member at an uppermost position of the display device DD in a third direction DR3 may be defined as the display surface DD-IS.

The third direction DR3 may indicate a normal line direction of the display surface DD-IS, e.g., a thickness direction of the display device DD. Front (or upper) and rear (or lower) surfaces of each layer or each unit may be distinguished from each other in the third direction DR3.

The display device DD may include a display area DA and a non-display area NDA. Unit pixels PXU may be provided in the display area DA, and the unit pixels PXU may not be arranged in the non-display area NDA. The non-display area NDA may be defined along an edge of the display surface DD-IS. The non-display area NDA may surround the display area DA. According to an embodiment, the non-display area NDA may be omitted or may be defined adjacent to only one side of the display area DA. FIG. 1A shows a flat display device DD as a representative example, however, the display device DD may have a curved shape, may be folded and/or rolled, and/or may be slid from a housing.

The unit pixels PXU shown in FIG. 1A may define a pixel row and a pixel column. The unit pixel PXU may be the smallest repeating unit and may include at least one pixel. The unit pixel PXU may include a plurality of pixels that provide lights having different colors from each other.

Referring to FIG. 1B, the display device DD may include a display panel DP and a light conversion panel OP facing the display panel DP and spaced apart from the display panel DP. The display panel DP may be referred to as a lower display substrate, and the light conversion panel OP may be referred to as an upper display substrate. A set or predetermined cell gap may be defined between the display panel DP and the light conversion panel OP. The cell gap may be maintained by a sealing member SLM that couples the display panel DP and the light conversion panel OP together. The sealing member SLM may include a binder resin and inorganic fillers mixed together with the binder resin. The sealing member SLM may further include other additives. The additives may include an amine-based curing agent and a photoinitiator. The additives may further include a silane-based additive and an acrylic-based additive. The sealing member SLM may include an inorganic-based material such as a frit.

Each of the display panel DP and the light conversion panel OP may include a display area DA and a non-display area NDA defined therein to be the same as the display area DA and the non-display area NDA of the display device DD. Hereinafter, the display area DA of the display device DD may indicate the display area DA of each of the display panel DP and the light conversion panel OP, and the non-display area NDA of the display device DD may indicate the non-display area NDA of each of the display panel DP and the light conversion panel OP.

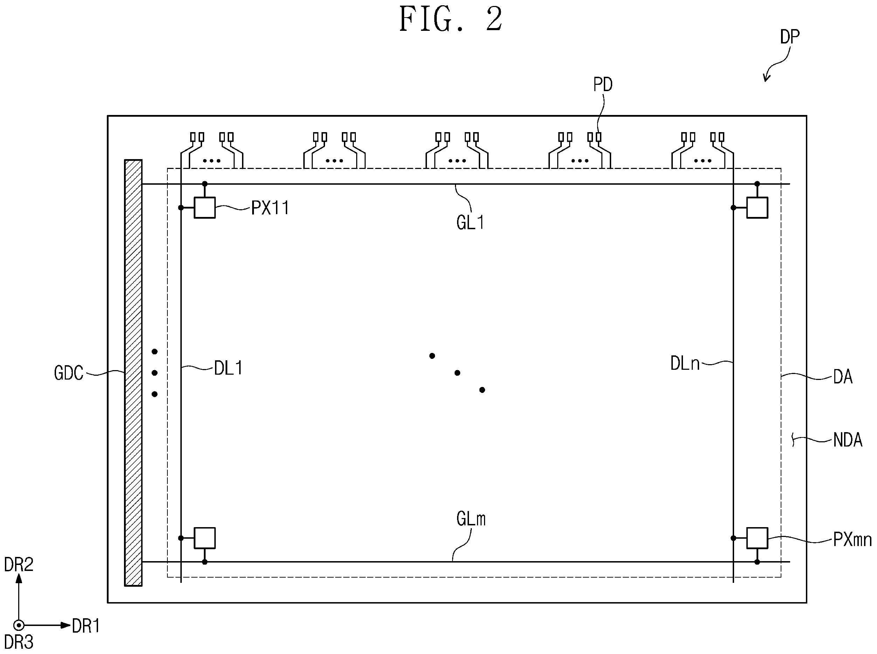

FIG. 2 is a plan view of the display panel DP according to an embodiment of the present disclosure.

FIG. 2 shows an arrangement relationship of signal lines GL1 to GLm and DL1 to DLn and pixels PX11 to PXnm on a plan view. The signal lines GL1 to GLm and DL1 to DLn may include a plurality of gate lines GL1 to GLm and a plurality of data lines DL1 to DLn.

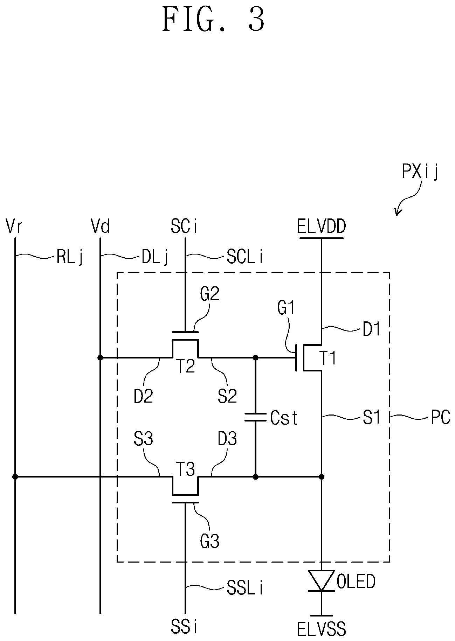

Each of the pixels PX11 to PXnm may be connected to a corresponding gate line among the gate lines GL1 to GLm and a corresponding data line among the data lines DL1 to DLn. Each of the pixels PX11 to PXnm may include a pixel driving circuit and a light emitting element. More types (or kinds) of signal lines may be provided in the display panel DP according to a configuration of the pixel driving circuit of each of the pixels PX11 to PXnm. As an example, each of the gate lines GL1 to GLm may include a corresponding scan line SCLi (refer to FIG. 3) and a corresponding sensing line SSLi (refer to FIG. 3).

A gate driving circuit GDC may be integrated in the display panel DP through an oxide silicon gate driver circuit (OSG) process and/or an amorphous silicon gate driver circuit (ASG) process. The gate driving circuit GDC connected to the gate lines GL1 to GLm may be provided at one side of the non-display area NDA in the first direction DR1. Pads PD connected to ends of the data lines DL1 to DLn may be provided at one side of the non-display area NDA in the second direction DR2.

FIG. 3 is an equivalent circuit diagram of a pixel PXij according to an embodiment of the present disclosure.

FIG. 3 shows the pixel PXij connected to an i-th scan line SCLi, an i-th sensing line SSLi, a j-th data line DLj, and a j-th reference line RLj as a representative example. The pixel PXij may include a pixel circuit PC and a light emitting element OLED electrically connected to the pixel circuit PC. The pixel circuit PC may include a plurality of transistors T1, T2, and T3 and a capacitor Cst. The transistors T1 to T3 may be formed through a low temperature polycrystalline silicon (LTPS) process and/or a low temperature polycrystalline oxide (LTPO) process. Hereinafter, the transistors T1 to T3 will be described as an N-type transistor, however, it should not be limited thereto or thereby. According to an embodiment, at least one selected from the transistors T1 to T3 may be a P-type transistor.

In the present embodiment, the pixel circuit PC including a first transistor T1, a second transistor T2, a third transistor T3, and the capacitor Cst is shown. However, the pixel circuit PC should not be limited thereto or thereby. The first transistor T1 may be referred to as a driving transistor, the second transistor T2 may be referred to as a switching transistor, and the third transistor T3 may be referred to as a sensing transistor. According to an embodiment, the pixel circuit PC may further include an additional transistor and/or an additional capacitor.

The light emitting element OLED may be an organic light emitting element, which includes an anode (a first electrode) and a cathode (a second electrode), or an inorganic light emitting element. The anode of the light emitting element OLED may receive a first voltage ELVDD via the first transistor T1, and the cathode of the light emitting element OLED may receive a second voltage ELVSS. The light emitting element OLED may emit the light in response to the first voltage ELVDD and the second voltage ELVSS.

The first transistor T1 may include a drain D1 that receives the first voltage ELVDD, a source S1 connected to the anode of the light emitting element OLED, and a gate G1 connected to the capacitor Cst. The first transistor T1 may control a driving current that flows from the first voltage ELVDD to the light emitting element OLED in response to a level of a voltage charged in the capacitor Cst.

The second transistor T2 may include a drain D2 connected to the j-th data line DLj, a source S2 connected to the capacitor Cst, and a gate G2 receiving an i-th first scan signal SCi. The j-th data line DLj may receive a data voltage Vd. The second transistor T2 may apply the data voltage Vd to the first transistor T1 in response to the i-th first scan signal SCi.

The third transistor T3 may include a source S3 connected to the j-th reference line RLj, a drain D3 connected to the anode of the light emitting element OLED, and a gate G3 that receives an i-th second scan signal SSi. The j-th reference line RLj may receive a reference voltage Vr. The third transistor T3 may initialize the capacitor Cst and the anode of the light emitting element OLED.

The capacitor Cst may be charged with a voltage corresponding to a difference between the voltage from the second transistor T2 and the first voltage ELVDD. The capacitor Cst may be connected to the gate G1 of the first transistor T1 and the anode of the light emitting element OLED.

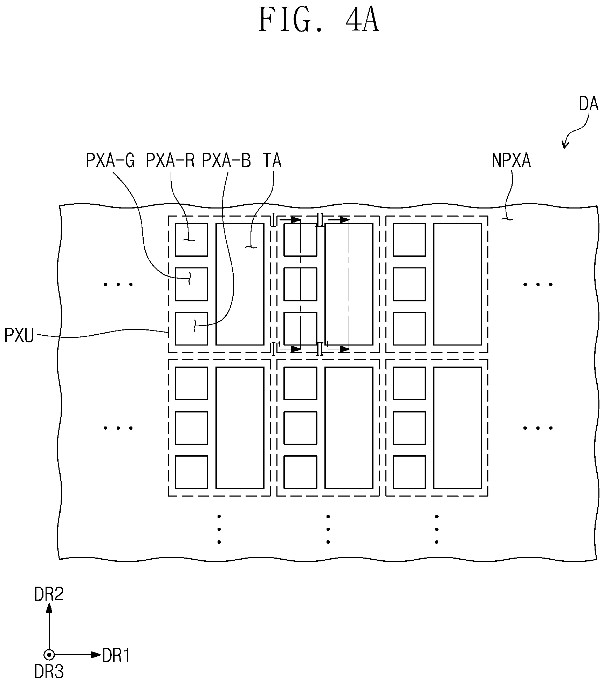

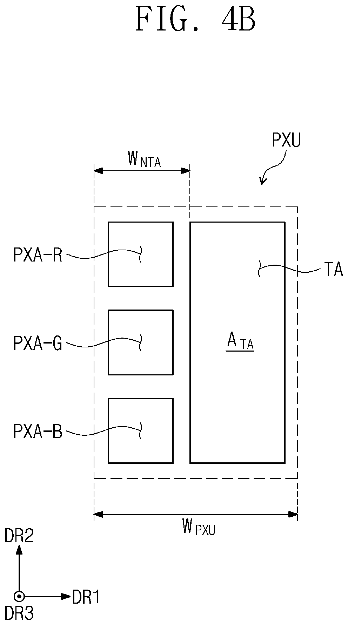

FIG. 4A is an enlarged plan view of the display area DA according to an embodiment of the present disclosure. FIG. 4B is an enlarged plan view of the display area DA (refer to FIG. 4A) according to an embodiment of the present disclosure. FIG. 4B is an enlarged view of one pixel unit PXU of FIG. 4A.

Referring to FIG. 4A, the unit pixels PXU may be provided in the first direction DR1 and the second direction DR2. In the present embodiment, the unit pixel PXU may include a first pixel, a second pixel, and a third pixel, which emit lights having different colors from each other. The first pixel, the second pixel, and the third pixel may emit a red light, a green light, and a blue light, respectively. FIG. 4A shows a first pixel area PXA-R, a second pixel area PXA-G, and a third pixel area PXA-B as representative examples of the first pixel, the second pixel, and the third pixel, respectively. The first pixel area PXA-R may be an area where a light generated by the first pixel is emitted outward, the second pixel area PXA-G may be an area where a light generated by the second pixel is emitted outward, and the third pixel area PXA-B may be an area where a light generated by the third pixel is emitted outward.

A peripheral area NPXA may be defined to surround the first, second, and third pixel areas PXA-R, PXA-G, and PXA-B. In embodiments, the peripheral area NPXA may be defined between the first, second, and third pixel areas PXA-R, PXA-G, and PXA-B. The peripheral area NPXA may define a boundary of the first, second, and third pixel areas PXA-R, PXA-G, and PXA-B and may prevent or reduce color mixing between the first, second, and third pixel areas PXA-R, PXA-G, and PXA-B.

The first pixel area PXA-R, the second pixel area PXA-G, and the third pixel area PXA-B may be spaced apart from each other in the second direction DR2. FIG. 4A shows a structure in which the first pixel area PXA-R, the second pixel area PXA-G, and the third pixel area PXA-B have substantially the same size as each other, however, this is merely an example. In embodiments, each of the first pixel area PXA-R, the second pixel area PXA-G, and the third pixel area PXA-B shown in FIG. 4A may have a substantially square shape, however, the present disclosure should not be limited thereto or thereby.

The unit pixel PXU may include a transmissive area TA spaced apart from each of the first pixel area PXA-R, the second pixel area PXA-G, and the third pixel area PXA-B in the first direction DR1. The transmissive area TA may have a light transmittance higher than the first pixel area PXA-R, the second pixel area PXA-G, and the third pixel area PXA-B. As the display device DD (refer to FIG. 1) includes the transmissive area TA defined in the display area DA, a transparent display device may be implemented. In the present embodiment, the transparent display device may refer to a display device that allows the user to recognize the image displayed by emitting the light from the light emitting elements of the display device and to concurrently (e.g., simultaneously) recognize the light passing through the display device through the transmissive area TA.

Referring to FIG. 4B, the unit pixel PXU may have a width W_{PXU} equal to or greater than about 600 µm and equal to or smaller than about 660 µm. The width W_{PXU} of the unit pixel PXU may correspond to a length in the first direction DR1 of the unit pixel PXU. As an example, the width W_{PXU} in the first direction DR1 of the unit pixel PXU may be about 630 µm.

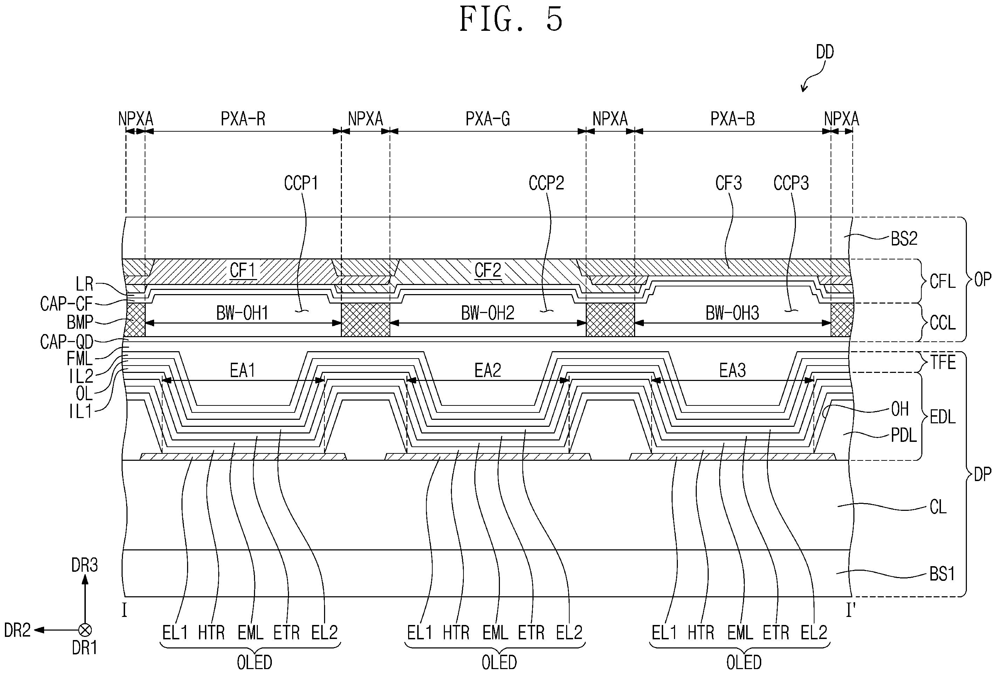

A width W_{NTA}, e.g., a length in the first direction DR1, of a portion including the first, second, and third pixel areas PXA-R, PXA-G, and PXA-B and the peripheral area NPXA surrounding the first, second, and third pixel areas PXA-R, PXA-G, and PXA-B of the unit pixel PXU may be equal to or greater than about 180 µm and equal to or smaller than about 220 µm. The portion including the first, second, and third pixel areas PXA-R, PXA-G, and PXA-B and the peripheral area NPXA surrounding the first, second, and third pixel areas PXA-R, PXA-G, and PXA-B may be defined as an area in which color filters CF1, CF2, and CF3 (refer to FIG. 5) are provided. As an example, the width W_{NTA} including the first, second, and third pixel areas PXA-R, PXA-G, and PXA-B and the peripheral area NPXA surrounding the first, second, and third pixel areas PXA-R, PXA-G, and PXA-B may be about 202 µm.

A size A_{TA} of the transmissive area TA relative to a size of the unit pixel PXU may be equal to or greater than about 55% or equal to or smaller than about 65%. As an example, the size A_{TA} of the transmissive area TA relative to the size of the unit pixel PXU may be about 59%.

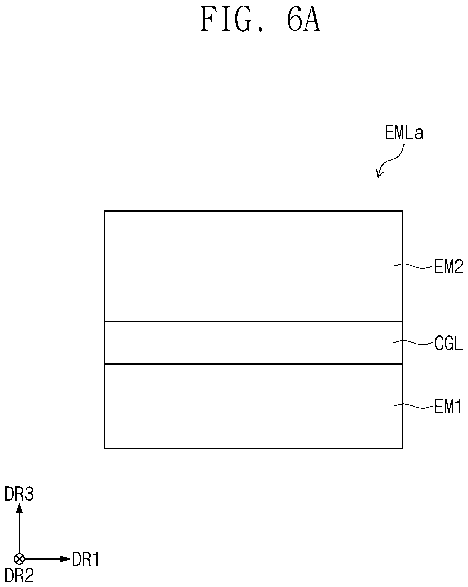

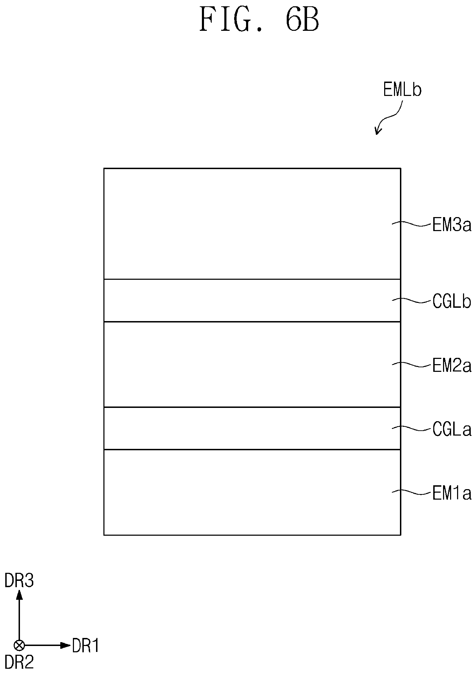

FIG. 5 is a cross-sectional view of the display device DD according to an embodiment of the present disclosure. FIGS. 6A and 6B are cross-sectional views of light emitting layers EMLa and EMLb according to various embodiments of the present disclosure.

FIG. 5 is a cross-sectional view taken along a line I-I' shown in FIG. 4A.

Referring to FIG. 5, the display panel DP may include a first base layer BS1, a circuit layer CL, a light emitting element layer EDL, and a thin film encapsulation layer TFE. The circuit layer CL may be on the first base layer BS1. The light emitting element layer EDL may be on the circuit layer CL. The thin film encapsulation layer TFE may be on the light emitting element layer EDL and may encapsulate the light emitting element layer EDL.

The first base layer BS1 may include a glass and/or synthetic resin layer. The synthetic resin layer may include a thermosetting resin. The synthetic resin layer may be a polyimide-based resin layer, however, it should not be limited thereto or thereby. The synthetic resin layer may include at least one selected from an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. The first base layer BS1 may include a glass substrate, a metal substrate, and/or an organic/inorganic composite material substrate.

The circuit layer CL may be on the first base layer BS1. The circuit layer CL may include an insulating layer, a semiconductor pattern, a conductive pattern, and a signal line. An insulating layer (e.g., an electrically insulating layer), a semiconductor layer, and a conductive layer (e.g., an electrically conductive layer) may be formed on the first base layer BS1 by a coating and/or depositing process. Then, the insulating layer, the semiconductor layer, and the conductive layer may be selectively patterned by several photolithography processes. In this way, the semiconductor pattern, the conductive pattern, and the signal line included in the circuit layer CL may be formed. The circuit layer CL may include a transistor, a buffer layer, and a plurality of insulating layers (e.g., a plurality of electrically insulating layers).

The light emitting element layer EDL may be on the circuit layer CL and may include a light emitting element OLED and a pixel definition layer PDL.

The light emitting element OLED may include a first electrode EL1, a second electrode EL2 facing the first electrode EL1, and a light emitting layer EML between the first electrode EL1 and the second electrode EL2. The light emitting layer EML included in the light emitting element OLED may include an organic light emitting material and/or a quantum dot as its light emitting material. The light emitting element OLED may further include a hole transport region HTR and/or an electron transport region ETR. In embodiments, the light emitting element OLED may further include a capping layer above the second electrode EL2.

The pixel definition layer PDL may be on the circuit layer CL and may cover portions of the first electrode EL1. The pixel definition layer PDL may be provided with a light emitting opening OH defined therethrough. At least portions of the first electrode EL1 may be exposed through the light emitting opening OH of the pixel definition layer PDL. First, second, and third light emitting areas EA1, EA2, and EA3 may be defined to respectively correspond to the portions of the first electrode EL1 exposed through the light emitting opening OH. The first light emitting area EA1, the second light emitting area EA2, and the third light emitting area EA3 may correspond to the first pixel area PXA-R, the second pixel area PXA-G, and the third pixel area PXA-B, respectively. An area except the first, second, and third light emitting areas EA1, EA2, and EA3 may be defined as a non-light-emitting area.

In the present disclosure, the expression "Two components correspond to each other" means that "Two components overlap each other" when viewed in the thickness direction DR3 of the display device DD, however, they should not be limited to having the same size. The first, second, and third light emitting areas EA1, EA2, and EA3 may overlap the first, second, and third pixel areas PXA-R, PXA-G, and PXA-B, respectively. When viewed in a plane, the respective sizes of the first, second, and third pixel areas PXA-R, PXA-G, and PXA-B may be greater than the respective sizes of the first, second, and third light emitting areas EA1, EA2, and EA3 distinguished from each other by the pixel definition layer PDL, however, this is merely an example, and the present disclosure should not be limited thereto or thereby. According to an embodiment, the respective sizes of the first, second, and third pixel areas PXA-R, PXA-G, and PXA-B may be substantially the same as the respective sizes of the first, second, and third light emitting areas EA1, EA2, and EA3 distinguished from each other by the pixel definition layer PDL.

The first electrode EL1 may be on the circuit layer CL. The first electrode EL1 may be an anode or a cathode. According to an embodiment, the first electrode EL1 may be a pixel electrode. The first electrode EL1 may be a transmissive electrode, a transflective electrode, or a reflective electrode.

The hole transport region HTR may be on the first electrode EL1. The hole transport region HTR may be commonly provided in the first, second, and third light emitting areas EA1, EA2, and EA3 and the non-light-emitting area. The hole transport region HTR may be provided as a common layer to overlap the unit pixels PXU provided in the display area DA shown in FIG. 4A, however, the present disclosure should not be limited thereto or thereby. According to an embodiment, the hole transport region HTR may be patterned into portions to respectively correspond to the first, second, and third light emitting areas EA1, EA2, and EA3. The hole transport region HTR may include at least one selected from a hole transport layer, a hole injection layer, and an electron blocking layer.

The light emitting layer EML may be on the hole transport region HTR. According to an embodiment, the light emitting layer EML may be commonly provided in the first, second, and third light emitting areas EA1, EA2, and EA3 and the non-light-emitting area. The light emitting layer EML may entirely overlap the hole transport region HTR and the electron transport region ETR, however, the present disclosure should not be limited thereto or thereby. According to an embodiment, the light emitting layer EML may be provided only in the light emitting opening OH. For example, the light emitting layer EML may be provided after being divided into a plurality of portions to respectively correspond to the first, second, and third light emitting areas EA1, EA2, and EA3, which are distinguished from each other by the pixel definition layer PDL.

The light emitting layer EML may generate a source light. The light emitting layer EML may emit the blue light. In the display device DD according to the present embodiment, the source light may be the blue light. In embodiments, when the light emitting layer EML is divided into a plurality of portions to respectively correspond to the light emitting areas EA1, EA2, and EA3, all the portions of the light emitting layer EML may emit the blue light, or the portions of the light emitting layer EML may emit lights in different wavelength ranges from each other.

The light emitting layer EML may have a single-layer structure of a single material, a single-layer structure of a plurality of different materials, or a multi-layer structure of a plurality of layers formed of different materials. The light emitting layer EML may include a fluorescent and/or phosphorescent material. According to an embodiment, the light emitting layer EML of the light emitting element may include an organic light emitting material, a metal organic complex, and/or a quantum dot as its light emitting material.

FIGS. 6A and 6B are cross-sectional views of the light emitting layer EML (refer to FIG. 5) having the multi-layer structures.

Referring to FIG. 6A, a light emitting layer EMLa may include a first light emitting layer EM1, a charge-generating layer CGL, and a second light emitting layer EM2, which are sequentially stacked in the third direction DR3. The first light emitting layer EM1 and the second light emitting layer EM2 may emit lights having different colors from each other. As an example, the first light emitting layer EM1 may emit blue light, and the second light emitting layer EM2 may emit green light.

The charge-generating layer CGL may be between the first light emitting layer EM1 and the second light emitting layer EM2. The charge-generating layer CGL may provide electrons or holes to each of the first light emitting layer EM1 and the second light emitting layer EM2 to improve a luminous efficiency.

Referring to FIG. 6B, a light emitting layer EMLb may include a first light emitting layer EM1a, a first charge-generating layer CGLa, a second light emitting layer EM2a, a second charge-generating layer CGLb, and a third light emitting layer EM3a, which are sequentially stacked in the third direction DR3.

One of the first light emitting layer EM1a, the second light emitting layer EM2a, and the third light emitting layer EM3a may emit a light having a color different from that of the other two of the first light emitting layer EM1a, the second light emitting layer EM2a, and the third light emitting layer EM3a. As an example, the first light emitting layer EM1a and the third light emitting layer EM3a may emit lights having the same color, and the second light emitting layer EM2a may emit a light having a different color from that of the light emitted from the first light emitting layer EM1a. As an example, the first light emitting layer EM1a and the third light emitting layer EM3a may emit blue light, and the second light emitting layer EM2a may emit green light.

The first charge-generating layer CGLa may be between the first light emitting layer EM1a and the second light emitting layer EM2a. The second charge-generating layer CGLb may be between the second light emitting layer EM2a and the third light emitting layer EM3a. The first charge-generating layer CGLa may provide electrons or holes to each of the first light emitting layer EM1a and the second light emitting layer EM2a to improve a luminous efficiency. In embodiments, the second charge-generating layer CGLb may provide electrons or holes to each of the second light emitting layer EM2a and the third light emitting layer EM3a to improve the luminous efficiency.

Referring to FIG. 5 again, the electron transport region ETR may be on the light emitting layer EML. The electron transport region ETR may include at least one selected from an electron injection layer, an electron transport layer, and a hole blocking layer. The electron transport region ETR may be provided as a common layer to entirely overlap the first, second, and third light emitting areas EA1, EA2, and EA3 and the pixel definition layer PDL, however, the present disclosure should not be limited thereto or thereby. According to an embodiment, the electron transport region ETR may be divided into a plurality of portions, and the divided portions of the electron transport region ETR may be arranged to respectively correspond to the first, second, and third light emitting areas EA1, EA2, and EA3.

The second electrode EL2 may be on the electron transport region ETR. The second electrode EL2 may be a common electrode. The second electrode EL2 may be a cathode or an anode, however, it should not be limited thereto or thereby. As an example, when the first electrode EL1 is the anode, the second electrode EL2 may be the cathode, and when the first electrode EL1 is the cathode, the second electrode EL2 may be the anode. The second electrode EL2 may be a transmissive electrode, a transflective electrode, or a reflective electrode.

The thin film encapsulation layer TFE may be on the second electrode EL2. When the light emitting element OLED includes the capping layer, the thin film encapsulation layer TFE may be on the capping layer. The thin film encapsulation layer TFE may protect the light emitting element layer EDL from moisture and/or oxygen and may prevent or reduce entry of a foreign substance, such as dust particles, into the light emitting element layer EDL.

The thin film encapsulation layer TFE may include at least one inorganic layer, for example, two inorganic layers IL1 and IL2. The inorganic layers IL1 and IL2 may include at least one of silicon nitride, silicon oxynitride, silicon oxide, titanium oxide, or aluminium oxide. The thin film encapsulation layer TFE may include at least one organic layer OL. The organic layer OL may include an organic polymer material formed of an acrylic-based resin, however, it should not be particularly limited.

The light conversion panel OP may be on the display panel DP. The light conversion panel OP may include a second base layer BS2, a color filter layer CFL, and a light control layer CCL. The color filter layer CFL may be under the second base layer BS2. The light control layer CCL may be under the color filter layer CFL.

The second base layer BS2 may provide a base surface on which the color filter layer CFL is provided. The second base layer BS2 may be referred to as a base layer. The second base layer BS2 may include a glass layer and/or a synthetic resin layer. The synthetic resin layer may include a thermosetting resin. The synthetic resin layer may be a polyimide-based resin layer, however, it should not be particularly limited. The synthetic resin layer may include at least one selected from an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In embodiments, the second base layer BS2 may include a glass substrate, a metal substrate, and/or an organic/inorganic composite material substrate.

The color filter layer CFL may be under the second base layer BS2. The color filter layer CFL may include color filters CF1, CF2, and CF3. The color filter layer CFL may include a first color filter CF1 that transmits a second color light, a second color filter CF2 that transmits a third color light, and a third color filter CF3 that transmits a first color light. As an example, the first color filter CF1 may be a red filter, the second color filter CF2 may be a green filter, and the third color filter CF3 may be a blue filter. According to an embodiment, the first color filter CF1 and the second color filter CF2 may be a yellow filter. The first color filter CF1 and the second color filter CF2 may be provided integrally with each other without being distinguished from each other.

The first color filter CF1 may increase a color purity by transmitting only a light in a partial wavelength range of the second color light, for example, a light in a central wavelength range. The second color filter CF2 may increase a color purity by transmitting only a light in a partial wavelength range of the third color light, for example, a light in a central wavelength range. The third color filter CF3 may increase a color purity by transmitting only a light in a partial wavelength range of the first color light, for example, a light in a central wavelength range.

Each of the color filters CF1, CF2, and CF3 may include a polymer photoresist, and pigment and/or dye. The first color filter CF1 may include a red pigment and/or dye, the second color filter CF2 may include a green pigment and/or dye, and the third color filter CF3 may include a blue pigment and/or dye. In embodiments, the present disclosure should not be limited thereto or thereby. According to an embodiment, the third color filter CF3 may not include the pigment or the dye. The third color filter CF3 may include the polymer photoresist and may not include the pigment or the dye. The third color filter CF3 may be transparent. The third color filter CF3 may be formed of a transparent photosensitive resin.

The first, second, and third color filters CF1, CF2, and CF3 may correspond to the first pixel area PXA-R, the second pixel area PXA-G, and the third pixel area PXA-B, respectively. In embodiments, the first, second, and third color filters CF1, CF2, and CF3 may correspond to first, second, and third light control portions CCP1, CCP2, and CCP3, respectively.

In embodiments, the color filters CF1, CF2, and CF3 that transmit the lights having different colors from each other may overlap each other to correspond to the peripheral area NPXA defined between the pixel areas PXA-R, PXA-G, and PXA-B. The color filters CF1, CF2, and CF3 may overlap in the third direction DR3, e.g., the thickness direction. The area in which the color filters CF1, CF2, and CF3 overlap each other may define a boundary between the pixel areas PXA-R, PXA-G and PXA-B adjacent to each other.

When viewed in the plane, a size of an area in which only the first color filter CF1 is provided may be smaller than a size of the first light control portion CCP1. When viewed in the plane, a size of an area in which only the second color filter CF2 is provided may be smaller than a size of the second light control portion CCP2. When viewed in the plane, a size of an area in which only the third color filter CF3 is provided may be smaller than a size of the third light control portion CCP3. Accordingly, the size of the first pixel area PXA-R may be smaller than the size of the first light control portion CCP1, the size of the second pixel area PXA-G may be smaller than the size of the second light control portion CCP2, and the size of the third pixel area PXA-B may be smaller than the size of the third light control portion CCP3.

Different from the structure shown in FIG. 5, the color filter layer CFL may include a light blocking portion to define a boundary between the color filters CF1, CF2, and CF3 adjacent to each other. The light blocking portion may be formed as a blue color filter or may be formed of an organic light blocking material and/or an inorganic light blocking material including a black pigment and/or a black dye.

The color filter layer CFL may further include a low refractive layer LR. The low refractive layer LR may be under the color filters CF1, CF2, and CF3. The low refractive layer LR may be on the light control layer CCL. The low refractive layer LR may be between the light control layer CCL and the color filters CF1, CF2, and CF3 to serve as an optical functional layer that increases a light extraction efficiency or that prevents or reduces entry of a reflected light into the light control layer CCL. The low refractive layer LR may be a layer having a refractive index smaller than that of layers adjacent thereto.

The low refractive layer LR may include an organic layer. As an example, the low refractive layer LR may include a polymer resin and inorganic particles. The low refractive layer LR may further include hollow particles and/or voids distributed in the organic layer, and the refractive index of the low refractive layer LR may be controlled by a ratio of the hollow particles and/or the voids.

The low refractive layer LR may have a single-layer or multi-layer structure. As shown in FIG. 5, the low refractive layer LR may include a single layer.

The color filter layer CFL may further include a color filter capping layer CAP-CF. The color filter capping layer CAP-CF may be referred to as an upper capping layer or a first capping layer. The color filter capping layer CAP-CF may be under the low refractive layer LR. The color filter capping layer CAP-CF may prevent moisture and/or oxygen from entering thereto. The color filter capping layer CAP-CF may prevent or reduce exposure of the color filters CF1, CF2, and CF3 and/or the low refractive layer LR to moisture/oxygen.

The color filter capping layer CAP-CF may include an inorganic layer. As an example, the color filter capping layer CAP-CF may include silicon nitride, aluminium nitride, zirconium nitride, titanium nitride, hafnium nitride, tantalum nitride, silicon oxide, aluminium oxide, titanium oxide, tin oxide, cerium oxide, and/or silicon oxynitride, and/or a metal thin film having light transmittance, however, it should not be limited thereto or thereby.

The light control layer CCL may be under the color filter layer CFL. The light control layer CCL may be provided at a lowermost position in the light conversion panel OP.

The light control layer CCL may include a partition pattern BMP and the light control portions CCP1, CCP2, and CCP3. When viewed in the plane, the partition pattern BMP may overlap the peripheral area NPXA. The light control portions CCP1, CCP2, and CCP3 included in the light control layer CCL may be spaced apart from each other. The light control portions CCP1, CCP2, and CCP3 may be spaced apart from each other by the partition pattern BMP. The light control portions CCP1, CCP2, and CCP3 may be respectively provided in openings BW-OH1, BW-OH2, and BW-OH3 defined through the partition pattern BMP, however, the present disclosure should not be limited thereto or thereby. Edges of the light control portions CCP1, CCP2, and CCP3 may at least partially overlap the partition pattern BMP.

The partition pattern BMP may include a material having a transmittance (e.g., a light transmittance) equal to or smaller than a set or predetermined value. As an example, the partition pattern BMP may include a light shielding material, e.g., a black coloring agent. The partition pattern BMP may include a base resin and a black dye and/or pigment mixed together with the base resin. As an example, the black coloring agent may include carbon black and/or a metal material, such as chromium and/or an oxide thereof. The partition pattern BMP may include at least one selected from propylene glycol methyl ether acetate, 3-methoxy-n-butyl acetate, acrylate monomer, acrylic monomer, organic pigment, and acrylate ester.

The light control portions CCP1, CCP2, and CCP3 may convert a wavelength of a source light provided from the light emitting element layer EDL or may transmit the source light without converting the wavelength of the source light. The light control portions CCP1, CCP2, and CCP3 may be formed by an inkjet process. A liquid ink composition may be provided in the openings BW-OH1, BW-OH2, and BW-OH3, and the provided ink composition may be polymerized by a heat curing process and/or a light curing process to form the light control portions CCP1, CCP2, and CCP3. For example, the openings BW-OH1, BW-OH2, and BW-OH3 may have shapes that respectively correspond to shapes of the light control portions CCP1, CCP2, and CCP3.

The light control layer CCL may include the first light control portion CCP1 including a first quantum dot that converts the first color light provided from the light emitting element OLED to the second color light, the second light control portion CCP2 including a second quantum dot that converts the first color light to the third color light, and the third light control portion CCP3 that transmits the first color light. The first light control portion CCP1 may provide the red light that is the second color light, and the second light control portion CCP2 may provide the green light that is the third color light. The third light control portion CCP3 may transmit the blue light that is the first color light provided from the light emitting element OLED. As an example, the first quantum dot may be a red quantum dot, and the second quantum dot may be a green quantum dot.

In embodiments, the quantum dots may refer to crystals of semiconductor compound. Because the energy band gap may be adjusted by controlling a size of a quantum dot or a ratio of elements in compounds for the quantum dots, lights having one or more suitable wavelengths may be obtained. As an example, each quantum dot may have a diameter of about 1 nm to about 10 nm. Accordingly, as the quantum dots described above, e.g., the quantum dots having different sizes or having the compounds having different ratios of elements from each other, are used, the light emitting element that emits the lights of one or more suitable wavelengths may be implemented. In more detail, the quantum dots may be implemented to emit the red, green and/or blue light. In embodiments, the quantum dot may be configured to emit a white light by combination of the lights having various suitable colors.

The quantum dots may be synthesized by a wet chemical process, a metal organic chemical vapor deposition process, a molecular beam epitaxy process, and/or similar processes. The wet chemical process is a method of growing quantum dot particle crystals after mixing an organic solvent together with a precursor material. When the crystals grow, the organic solvent may naturally serve as a dispersant coordinated to the surface of the quantum dot crystal and may control the growth of the crystals. Accordingly, the wet chemical process may control the growth of quantum dot particles more conveniently and cost-effectively than vapor deposition methods, such as the metal organic chemical vapor deposition (MOCVD) process and/or the molecular beam epitaxy (MBE) process.

The quantum dot may have a single structure in which the concentration of each element in the quantum dot is substantially uniform, or a core-shell dual structure. For example, a material included in the core and a material included in the shell may be different from each other. The shell of the quantum dot may serve as a protective layer that prevents or reduces chemical modification of the core to maintain semiconductor properties and/or may serve as a charging layer that imparts electrophoretic properties to the quantum dot. The shell may have a single-layer or multi-layer structure. In the core/shell structure, the concentration of elements existing in the shell may have a concentration gradient that is lowered as a distance from the core (e.g., a center of the core) decreases.

The core of quantum dots may be selected from a group II-VI compound, a group III-VI compound, a group I-III-VI compound, a group III-V compound, a group III-II-V compound, a group IV-VI compound, a group IV element, a group IV compound, and a combination thereof.

The group II-VI compound may be selected from a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, and a mixture thereof.

The group III-VI compound may include a binary compound, such as In₂S₃, In₂Se₃, etc., a ternary compound, such as InGaSs, InGaSes, etc., or any combination thereof.

The group I-III-VI compound may include a ternary compound selected from the group consisting of AgInS, AgInS₂, CuInS, CuInS₂, AgGaS₂, CuGaS₂ CuGaO₂, AgGaO₂, AgAlO₂, and a mixture thereof, and/or a quaternary compound of AgInGaS₂, CuInGaS₂, and/or the like.

The group III-V compound may be selected from a binary compound selected from the group consisting of GaN, GaP, GaAs, GaSb, AIN, AlP, AlAs, AlSb, InN, InP, InAs, InSb, and a mixture thereof, a ternary compound selected from the group consisting of GaNP, GaNAs, GaNSb, GaPAs, GaPSb, AINP, AINAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof. The group III-V compound may further include a group II metal. For instance, InZnP may be selected as a group III-II-V compound.

The group IV-VI compound may be selected from a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof. The group IV element may be selected from the group consisting of Si, Ge, and a mixture thereof. The group IV compound may be a binary compound selected from the group consisting of SiC, SiGe, and a mixture thereof.

The group IV element or compound may include a mono-element compound such as Si, Ge, etc., a binary compound such as SiC, SiGe, etc., or any suitable combination thereof.

Each element included in a multi-element compound, such as the binary compound, the ternary compound, and/or the quaternary compound, may be present in the particles at a uniform or non-uniform concentration. For example, the above chemical formula means the types (or kinds) of elements included in the compound, and an element ratio in the compound may be variable. As an example, AgInGaS₂ may mean AgInₓGa₁₋ₓS₂ (x is a real number between 0 to 1).

The shell of the quantum dots may include metal oxides and/or non-metal oxides, semiconductor compounds, or combinations thereof as its representative example.

The metal oxides and/or non-metal oxides may include a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and/or a ternary compound, such as MgAl₂O₄, CoFe₂O₄, NiFe₂O₄, CoMn₂O₄, however, they should not be limited thereto or thereby.

In addition, the semiconductor compounds may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and/or AlSb, however, they should not be limited thereto or thereby.

The quantum dot may have a full width at half maximum (FWHM) of a light emission wavelength spectrum of about 45 nm or less, about 40 nm or less, or, for example, about 30 nm or less. The color purity and the color reproducibility may be improved within the above ranges. In embodiments, because the light emitted through the quantum dots may be emitted in all (e.g., substantially all) directions, an optical viewing angle may be improved.

In embodiments, the shape of the quantum dot may have any suitable shape generally used in the art, however, it should not be particularly limited. In more detail, spherical, pyramidal, multi-arm, and/or cubic nanoparticles, nanotubes, nanowires, nanofibers, nanoplatelets, and/or the like may be applied to the quantum dots.

As described above, the quantum dot may control the color of the emitted light depending on a particle size thereof, and accordingly, the quantum dot may have various suitable emission colors such as blue, green, and red colors. As the particle size of the quantum dot decreases, the wavelength of the light emitted from the quantum dot becomes shorter. For example, the particle size of the quantum dot that emits the green light may be smaller than the particle size of the quantum dot that emits the red light in the quantum dots having the same core. In embodiments, the particle size of the quantum dots that emits the blue light may be smaller than the particle size of the quantum dot that emits the green light in the quantum dots having the same core. However, the present disclosure should not be limited thereto or thereby, and in the quantum dots having the same core, the particle size may be adjusted depending on a material for the shell and a thickness of the shell. In embodiments, when the quantum dots have various suitable emission colors such as blue, red, green, etc., materials for cores of the quantum dots having different emission colors may be different from each other.

The light control layer CCL may further include a scatterer (e.g., a light scatterer). The first light control portion CCP1 may include the first quantum dot and the scatterer, the second light control portion CCP2 may include the second quantum dot and the scatterer, and the third light control portion CCP3 may include the scatterer without including the quantum dot.

The scatterer may be an inorganic particle. As an example, the scatterer may include at least one selected from TiO₂, ZnO, Al₂O₃, SiO₂, and a hollow silica particle. The scatterer may include one selected from TiO₂, ZnO, Al₂O₃, SiO₂, and the hollow silica particle or may include two or more selected from TiO₂, ZnO, Al₂O₃, SiO₂, and the hollow silica, which are mixed together with each other.

Each of the first light control portion CCP1, the second light control portion CCP2, and the third light control portion CCP3 may further include a base resin in which the quantum dots and the scatterer are dispersed. According to an embodiment, the first light control portion CCP1 may include the first quantum dot and the scatterer, which are dispersed in the base resin, the second light control portion CCP2 may include the second quantum dot and the scatterer, which are dispersed in the base resin, and the third light control portion CCP3 may include the scatterer dispersed in the base resin.

The base resin may be a medium in which the quantum dots and the scatterer are dispersed and may include various suitable resin compositions that are generally referred to as a binder. As an example, the base resin may be an acrylate-based resin, a urethane-based resin, a silicone-based resin, and/or an epoxy-based resin. The base resin may be a transparent resin.

The light control layer CCL may further include a quantum dot capping layer CAP-QD under the light control portions CCP1, CCP2, and CCP3. The quantum dot capping layer CAP-QD may referred to as a lower capping layer or a second capping layer. The quantum dot capping layer CAP-QD may prevent or reduce entry of moisture and/or oxygen. The quantum dot capping layer CAP-QD may be under the light control portions CCP1, CCP2, and CCP3 to prevent or reduce exposure of the light control portions CCP1, CCP2, and CCP3 to moisture/oxygen. In embodiments, the quantum dot capping layer CAP-QD may cover one surface of the partition pattern BMP in addition to one surface of the light control portions CCP1, CCP2, and CCP3.

The quantum dot capping layer CAP-QD may include an inorganic layer. As an example, the quantum dot capping layer CAP-QD may include silicon nitride, aluminium nitride, zirconium nitride, titanium nitride, hafnium nitride, tantalum nitride, silicon oxide, aluminium oxide, titanium oxide, tin oxide, cerium oxide, and/or silicon oxynitride, and/or a metal thin film having light transmittance.

The display device DD may further include a filling layer FML between the display panel DP and the light conversion panel OP. The filling layer FML may be filled in between the display panel DP and the light conversion panel OP. The filling layer FML may function as a buffer between the display panel DP and the light conversion panel OP. The filling layer FML may have an impact absorbing function and may increase a strength of the display device DD. The filling layer FML may be formed of a filling resin including a polymer resin. As an example, the filling layer FML may be formed of a resin, such as an acrylic-based resin and/or an epoxy-based resin.

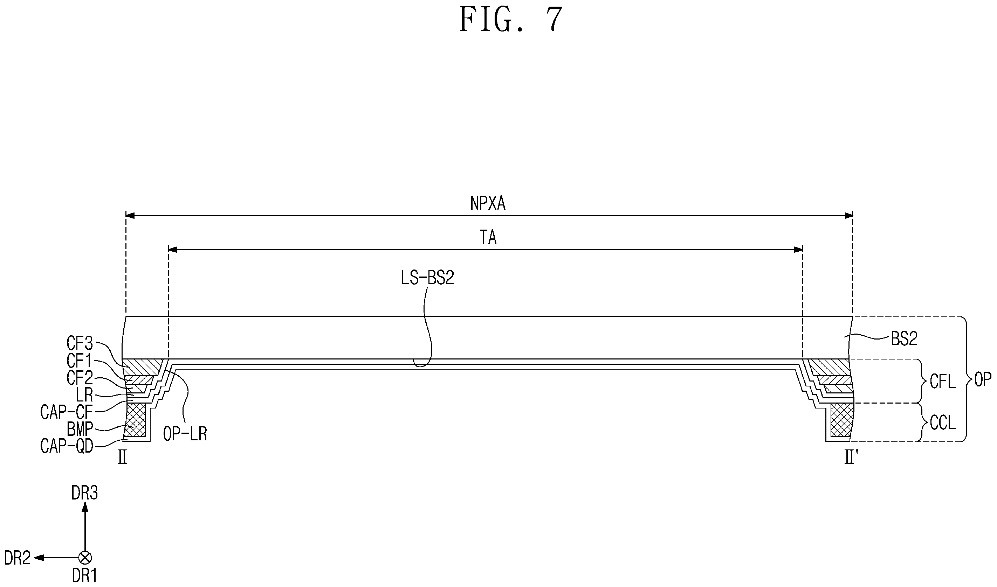

FIG. 7 is a cross-sectional view of the light conversion panel OP according to an embodiment of the present disclosure. FIG. 7 is a cross-sectional view taken along a line II-II' shown in FIG. 4A.

The color filters CF1, CF2, and CF3 may not overlap the transmissive area TA. The color filters CF1, CF2, and CF3 may be provided with openings substantially corresponding to the transmissive area TA.

The low refractive layer LR may be under the color filters CF1, CF2, and CF3. The low refractive layer LR may be directly under the color filters CF1, CF2, and CF3 and may cover a lower surface of the color filters CF1, CF2, and CF3. The low refractive layer LR may cover a side surface defining the openings of the color filters CF1, CF2, and CF3, which correspond to the transmissive area TA.

A transmission opening OP-LR may be defined through the low refractive layer LR to correspond to the transmissive area TA. A lower surface LS-BS2 of the second base layer BS2 may be exposed through the transmission opening OP-LR defined through the low refractive layer LR. In the present embodiment, the lower surface LS-BS2 of the second base layer BS2 may indicate a surface adjacent to the display panel DP (refer to FIG. 5). The second base layer BS2 may be referred to as a base layer.

The transmission opening OP-LR may be formed by removing a portion of the low refractive layer LR in the transmissive area TA using a photolithography process after the low refractive layer LR is formed on the entire portion of the color filters CF1, CF2, and CF3. According to an embodiment, when the low refractive layer LR includes a material for which the photolithography process may not be applied, the transmission opening OP-LR may be formed through an ashing process after a photoresist is coated.

The low refractive layer LR may include the organic layer. As an example, the low refractive layer LR may include the polymer resin and the inorganic particles. The low refractive layer LR may further include the hollow particles and/or voids distributed in the organic layer.

According to the light conversion panel OP of the present disclosure, the low refractive layer LR including the organic layer may not be formed in the transmissive area TA, and the transmission opening OP-LR corresponding to the transmissive area TA may be formed through the low refractive layer LR. Accordingly, a deterioration in light transmittance of the transmissive area TA due to the organic layer may be prevented or reduced. For example, the light transmittance of the transmissive area TA may be improved.

The color filter capping layer CAP-CF may be on the lower surface LS-BS2 of the second base layer BS2, which is exposed through the transmission opening OP-LR. The color filter capping layer CAP-CF may be referred to as the first capping layer. In the transmissive area TA, the color filter capping layer CAP-CF may be directly on the lower surface LS-BS2 of the second base layer BS2 and may cover the lower surface LS-BS2 of the second base layer BS2, which is exposed through the transmission opening OP-LR.

The color filter capping layer CAP-CF may include the inorganic layer. As an example, the color filter capping layer CAP-CF may include silicon nitride, aluminium nitride, zirconium nitride, titanium nitride, hafnium nitride, tantalum nitride, silicon oxide, aluminium oxide, titanium oxide, tin oxide, cerium oxide, and/or silicon oxynitride, and/or a metal thin film having light transmittance, however, it should not be limited thereto or thereby.

The partition pattern BMP may be under the color filter capping layer CAP-CF. The partition pattern BMP may not overlap the transmissive area TA. The partition pattern BMP may surround the transmissive area TA when viewed in the plane.

The quantum dot capping layer CAP-QD may be under the partition pattern BMP. The quantum dot capping layer CAP-QD may be referred to as the second capping layer. In the transmissive area TA, the quantum dot capping layer CAP-QD may be under the color filter capping layer CAP-CF. In the transmissive area TA, the quantum dot capping layer CAP-QD may be directly under the color filter capping layer CAP-CF.

The quantum dot capping layer CAP-QD may include the inorganic layer. As an example, the quantum dot capping layer CAP-QD may include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, and/or a metal thin film having light transmittance.

According to the light conversion panel OP of the present disclosure, only the color filter capping layer CAP-CF and the quantum dot capping layer CAP-QD including the inorganic layer may be under the base layer BS2 in the transmissive area TA, and the low refractive layer LR including the organic layer may be not provided. Accordingly, the light transmittance of the transmissive area TA may be improved compared to when the low refractive layer LR including the organic layer is provided in the transmissive area TA.

Table 1 shows relative values of the light transmittance according to the thickness of the low refractive layer. The relative values of Table 1 represent a luminance of a light transmitted through the low refractive layer relative to a luminance of the source light.

**Table 1**

| Thickness of low refractive layer (µm) | Relative value of luminance of transmitted light |
|---|---|
| 0.8 | 22.33 |
| 1.2 | 21.74 |

Referring to Table 1, as the thickness of the low refractive layer increases, the luminance of the light transmitted through the low refractive layer is reduced. In more detail, when the thickness of the low refractive layer increases by about 0.4 µm, the luminance of the transmitted light is lowered to about 97%.

Because the low refractive layer decreases the light transmittance of the transmissive area, the light transmittance of the transmissive area may be improved by removing the low refractive layer in the transmissive area as the light conversion panel of the present disclosure.

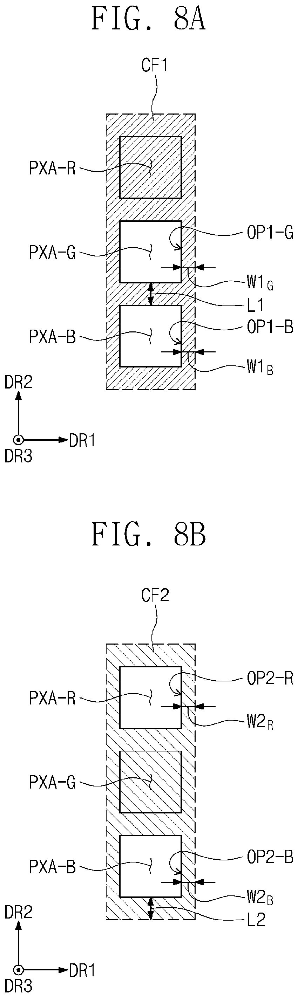

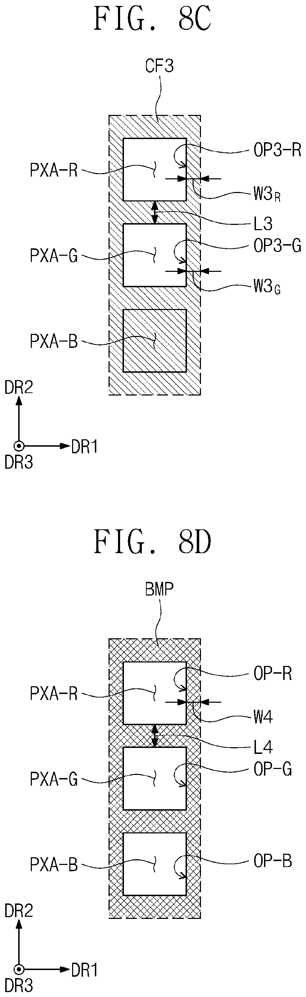

FIGS. 8A-8C are plan views of the color filters CF1, CF2, and CF3 according to an embodiment of the present disclosure. FIG. 8D is a plan view of the partition pattern BMP according to an embodiment of the present disclosure.

FIG. 8A shows the first color filter CF1 included in one unit pixel PXU (refer to FIG. 4A). The first color filter CF1 may overlap the first pixel area PXA-R. The first color filter CF1 may not overlap the second pixel area PXA-G and the third pixel area PXA-B. The first color filter CF1 may include a first-G opening OP1-G corresponding to the second pixel area PXA-G and a first-B opening OP1-B corresponding to the third pixel area PXA-B.

When viewed in the plane, a width W1_{G} of the first color filter CF1 provided at left and right sides (in the first direction DR1) of the second pixel area PXA-G may be equal to or greater than about 16 µm and equal to or smaller than about 22 µm. As an example, the width W1_{G} of the first color filter CF1 provided at the left and right sides (in the first direction DR1) of the second pixel area PXA-G may be about 19 µm.

When viewed in the plane, a width W1_{B} of the first color filter CF1 provided at left and right sides of the third pixel area PXA-B may be equal to or greater than about 21.5 µm and equal to or smaller than about 27.5 µm. As an example, the width W1_{B} of the first color filter CF1 provided at the left and right sides (first direction DR1) of the third pixel area PXA-B may be about 24.5 µm.

When viewed in the plane, a length L1 of the first color filter CF1 between the second pixel area PXA-G and the third pixel area PXA-B may be equal to or greater than about 27 µm and equal to or smaller than about 33 µm. As an example, the length L1 of the first color filter CF1 between the second pixel area PXA-G and the third pixel area PXA-B may be about 30 µm.

FIG. 8B shows the second color filter CF2 included in one unit pixel PXU (refer to FIG. 4A). The second color filter CF2 may overlap the second pixel area PXA-G. The second color filter CF2 may not overlap the first pixel area PXA-R and the third pixel area PXA-B. The second color filter CF2 may include a second-R opening OP2-R corresponding to the first pixel area PXA-R and a second-B opening OP2-B corresponding to the third pixel area PXA-B.

When viewed in the plane, a width W2_{R} of the second color filter CF2 provided at left and right sides (first direction DR1) of the first pixel area PXA-R may be equal to or greater than about 11 µm and equal to or smaller than about 17 µm. As an example, the width W2_{R} of the second color filter CF2 provided at the left and right sides (first direction DR1) of the first pixel area PXA-R may be about 14 µm.

When viewed in the plane, a width W2_{B} of the second color filter CF2 provided at left and right sides of the third pixel area PXA-B may be equal to or greater than about 11 µm and equal to or smaller than about 17 µm. As an example, the width W2_{B} of the second color filter CF2 provided at the left and right sides (first direction DR1) of the third pixel area PXA-B may be about 14 µm.

When viewed in the plane, a length L2 of the second color filter CF2 between the first pixel area PXA-R and the third pixel area PXA-B may be equal to or greater than about 15.5 µm and equal to or smaller than about 21.5 µm. As an example, the length L2 of the second color filter CF2 between the first pixel area PXA-R and the third pixel area PXA-B may be about 18.5 µm.

FIG. 8C shows the third color filter CF3 included in one unit pixel PXU (refer to FIG. 4A). The third color filter CF3 may overlap the third pixel area PXA-B. The third color filter CF3 may not overlap the first pixel area PXA-R and the second pixel area PXA-G. The third color filter CF3 may include a third-R opening OP3-R corresponding to the first pixel area PXA-R and a third-G opening OP3-G corresponding to the second pixel area PXA-G.

When viewed in the plane, a width W3_{R} of the third color filter CF3 provided at left and right sides (first direction DR1) of the first pixel area PXA-R may be equal to or greater than about 21 µm and equal to or smaller than about 27 µm. As an example, the width W3_{R} of the third color filter CF3 provided at the left and right sides (first direction DR1) of the first pixel area PXA-R may be about 24 µm.

When viewed in the plane, a width W3_{G} of the third color filter CF3 provided at left and right sides of the second pixel area PXA-G may be equal to or greater than about 21 µm and equal to or smaller than about 27 µm. As an example, the width W3_{G} of the third color filter CF3 provided at the left and right sides (in first direction DR1) of the second pixel area PXA-G may be about 24 µm.

When viewed in the plane, a length L3 of the third color filter CF3 between the first pixel area PXA-R and the second pixel area PXA-G may be equal to or greater than about 21 µm and equal to or smaller than about 27 µm. As an example, the length L3 of the third color filter CF3 between the first pixel area PXA-R and the second pixel area PXA-G may be about 24 µm.

FIG. 8D shows the division pattern BMP included in one unit pixel PXU (refer to FIG. 4A) in the same area as shown in FIGS. 8A to 8C. The division pattern BMP may not overlap the first, second, and third pixel areas PXA-R, PXA-G, and PXA-B. The division pattern BMP may include openings OP-R, OP-G, and OP-B corresponding to the first, second, and third pixel areas PXA-R, PXA-G, and PXA-B, respectively.

When viewed in the plane, a width W4 in the first direction DR1 of the division pattern BMP surrounding the first, second, and third pixel areas PXA-R, PXA-G, and PXA-B may be equal to or greater than about 11 µm and equal to or smaller than about 17 µm. As an example, the width W4 in the first direction DR1 of the division pattern BMP surrounding the first, second, and third pixel areas PXA-R, PXA-G, and PXA-B may be about 14 µm.

When viewed in the plane, a length L4 in the second direction DR2 of the division pattern BMP surrounding the first, second, and third pixel areas PXA-R, PXA-G, and PXA-B may be equal to or greater than about 11 µm and equal to or smaller than about 17 µm. As an example, the length L4 in the second direction DR2 of the division pattern BMP surrounding the first, second, and third pixel areas PXA-R, PXA-G, and PXA-B may be about 14 µm.

Although embodiments of the present disclosure have been described, it is understood that the present disclosure should not be limited to these embodiments but various suitable changes and modifications can be made by one ordinary skilled in the art within the scope of the present disclosure as hereinafter claimed. Therefore, the disclosed subject matter should not be limited to any single embodiment described herein, and the scope of the present disclosure shall be determined according to the attached claims, and equivalents thereof.

Embodiments are set out in the following clauses:
Clause 1. A display device comprising a display area comprising a pixel area and a transmissive area spaced apart from the pixel area and a non-display area adjacent to the display area, comprising:
   a display panel comprising a light emitting element layer; and
   a light conversion panel disposed on the display panel, the light conversion panel comprising:
      a base layer;
      a color filter that does not overlap the transmissive area and is disposed under the base layer;
      a low refractive layer provided with a transmission opening defined therethrough and corresponding to the transmissive area and disposed under the color filter;
      a first capping layer disposed directly under the base layer exposed through the transmission opening; and
      a second capping layer disposed under the first capping layer.
Clause 2. The display device of clause 1, wherein the second capping layer is disposed directly under the first capping layer in the transmissive area.
Clause 3. The display device of clause 1 or clause 2, further comprising:
   a partition pattern surrounding the transmissive area and the pixel area and disposed under the first capping layer; and
   a plurality of light control portions disposed under the first capping layer to correspond to the pixel area.
Clause 4. The display device of clause 3, wherein the partition pattern comprises a side surface adjacent to the transmissive area, and the side surface of the partition pattern is covered by the second capping layer.
Clause 5. The display device of clause 3 or clause 4, wherein the partition pattern comprises a lower surface adjacent to the display panel, and the lower surface of the partition pattern is covered by the second capping layer.
Clause 6. The display device of any one of clauses 3 to 5, wherein the light control portions comprise a lower surface adjacent to the display panel, and the lower surface of the light control portions is covered by the second capping layer.
Clause 7. The display device of any one of clauses 1 to 6, further comprising a filling layer disposed between the display panel and the light conversion panel.
Clause 8. The display device of any one of clauses 1 to 7, wherein each of the first capping layer and the second capping layer comprises an inorganic material.
Clause 9. The display device of any one of clauses 1 to 8, wherein the low refractive layer comprises an organic material.

## Claims

1. A display device comprising a display area comprising a transmissive area and a non-display area adjacent to the display area, comprising:
a display panel comprising a light emitting element layer; and
a light conversion panel on the display panel, the light conversion panel comprising:
a base layer;
a color filter under the base layer;
a low refractive layer under the color filter;
a first capping layer under the low refractive layer; and
a light control layer under the color filter and comprising a partition pattern, a plurality of light control portions spaced apart from each other by the partition pattern, and a second capping layer under the partition pattern and the light control portions,
wherein the low refractive layer is provided with a transmission opening defined therethrough to correspond to the transmissive area.

2. The display device of claim 1, wherein the color filter does not overlap the transmissive area.

3. The display device of claim 1 or claim 2, wherein the base layer comprises a lower surface adjacent to the display panel, and the lower surface of the base layer is exposed through the transmission opening.

4. The display device of claim 3, wherein the first capping layer is directly on the lower surface of the base layer exposed through the transmission opening.

5. The display device of any one of claims 1 to 4, wherein the second capping layer is directly under the first capping layer in the transmissive area.

6. The display device of any one of claims 1 to 5, further comprising a filling layer between the display panel and the light conversion panel.

7. The display device of any one of claims 1 to 6, wherein each of the first capping layer and the second capping layer comprises an inorganic material.

8. The display device of any one of claims 1 to 7, wherein the low refractive layer comprises an organic material.

9. The display device of any one of claims 1 to 8, wherein the partition pattern surrounds the transmissive area when viewed in a plane, the partition pattern comprises a side surface adjacent to the transmissive area, and the side surface of the partition pattern is covered by the second capping layer.

10. The display device of any one of claims 1 to 9, wherein the partition pattern and the light control portions do not overlap the transmissive area.

11. The display device of any one of claims 1 to 10, wherein the display area further comprises a pixel area, and the pixel area is spaced apart from the transmissive area.
